(19) Europäisches Patentamt
European Patent Office
Office européen des brevets

(11) **EP 0 724 302 B1**

(12) **FASCICULE DE BREVET EUROPEEN**

(45) Date de publication et mention
de la délivrance du brevet:
**24.03.2004 Bulletin 2004/13**

(51) Int Cl.⁷: **H01L 43/08**, G11B 5/39

(21) Numéro de dépôt: **96400139.0**

(22) Date de dépôt: **22.01.1996**

(54) **Capteur magnétique à magnétorésistance géante, et son procédé de fabrication**

Magnetsensor mit einem Riesenmagnetowiderstand und sein Herstellungsverfahren

Magnetic sensor with a giant magnetoresistance, and its method of fabrication

(84) Etats contractants désignés:
**BE CH DE GB IT LI NL**

(30) Priorité: **24.01.1995 FR 9500763**

(43) Date de publication de la demande:
**31.07.1996 Bulletin 1996/31**

(73) Titulaire: **COMMISSARIAT A L'ENERGIE ATOMIQUE**
**75015 Paris (FR)**

(72) Inventeur: **Dieny, Bernard**
**F-38170 Seyssinet (FR)**

(74) Mandataire: **Poulin, Gérard et al**
**BREVALEX**
**3, rue du docteur Lancereaux**
**75008 Paris (FR)**

(56) Documents cités:
**EP-A- 0 628 835          DE-A- 4 312 040**
**US-A- 5 287 238**

EP 0 724 302 B1

**Description**

Domaine technique

La présente invention concerne de façon générale des détecteurs de champ ou de flux magnétiques, et plus particulièrement les capteurs magnétorésistifs du type utilisé par exemple pour la lecture d'informations inscrites sur un support magnétique. Elle concerne aussi les magnétorésistances qui constituent le composant sensible de ces capteurs. La magnétorésistance de l'invention, réalisée en couches minces selon des techniques de microélectronique, est particulièrement adaptée à la mesure de champs magnétiques de quelques A/m à quelques milliers d'A/m. Elle peut aussi être utilisée dans la détermination du courant électrique circulant dans des conducteurs à partir du champ magnétique régnant au voisinage de ces conducteurs, la réalisation de boussoles magnétorésistives ou encore de divers capteurs de position.

Etat de la technique antérieure

On sait que le fonctionnement des capteurs magnétorésistifs utilisés pour la détection de faibles champs magnétiques, notamment pour la lecture d'informations enregistrées sur un support magnétique, est fondé sur un effet communément appelé effet d'anisotropie spontanée de la magnétorésistance. Cet effet, qui se manifeste dans les métaux de transition ferromagnétiques tels que le nickel, le cobalt et le fer, et leurs alliages consiste en une variation de la résistivité du matériau magnétique en fonction de l'angle entre la direction du courant de mesure circulant dans l'élément magnétorésistif et l'aimantation du matériau. Pour une description plus détaillée de cet effet, on peut se reporter au document (1) référencé à la fin de la présente description. Le changement relatif de résistivité du matériau magnétique $\Delta\rho/\rho$ peut atteindre 4 à 5% à température ambiante pour des champs de l'ordre de 1000 A/m dans les métaux de transition ferromagnétiques massifs. Cette amplitude est néanmoins réduite à 1 ou 2% lorsque les mêmes matériaux sont déposés en couches minces, de l'ordre de 15 à 30 nm d'épaisseur. Ce domaine d'épaisseur est celui utilisé dans les capteurs magnétorésistifs actuels réalisés selon des techniques de fabrication des composants en microélectronique. La sensibilité de ces capteurs est donc limitée. Par ailleurs, leur réponse n'est pas linéaire du fait que la variation de résistivité est proportionnelle au carré du cosinus de l'angle entre la direction du courant et l'aimantation.

Un autre effet mis à profit dans des capteurs magnétiques est connu sous les désignations "effet de magnétorésistance géante" ou "effet de vanne de spin" ("giant magnetoresistance" ou "spin valve effect"). Cet effet se produit dans des structures multicouches formées d'une alternance de couches en métal de transition ferromagnétiques et de couches de métal non magnétique et est lié à un changement de l'orientation relative des aimantations des couches ferromagnétiques successives sous l'influence d'un champ magnétique extérieur à mesurer ; cet effet se traduit par une modification de la résistivité de la structure. Les documents (2) et (3) référencés à la fin de la présente description exposent avec plus de détails ce phénomène.

Le document (4), également référencé à la fin de la présente description, décrit de façon très générale l'application de cet effet de magnétorésistance à la réalisation de capteurs de champ magnétique. Il spécifie également que les matériaux employés, tels que le matériau magnétique et le matériau non magnétique, doivent être choisis pour qu'une diffusion des électrons dépendante de leur spin se produise à l'interface entre le matériau magnétique et le matériau non magnétique.

Le document (5) décrit une structure de "vanne de spin" comportant dans l'ordre un substrat en silicium, une première couche ferromagnétique en NiFe, une couche non magnétique de cuivre, une deuxième couche ferromagnétique en NiFe et une couche antiferromagnétique de FeMn.

Cette structure vanne de spin comprend donc essentiellement deux couches ferromagnétiques non couplées magnétiquement et séparées par un métal non magnétique.

L'aimantation de la première couche magnétique, dite couche magnétique "libre", est libre de suivre le champ appliqué alors que l'aimantation de la seconde couche est piégée par anisotropie d'échange avec la couche antiferromagnétique. Ainsi, lorsque le champ appliqué varie, l'orientation relative des aimantations des deux couches magnétiques change. Ceci entraîne aussi un changement de résistance de la structure qui peut être de quelques pourcents à la température ambiante, dans des champs appliqués inférieurs à 1000 A/m.

La faible valeur de la variation de la résistance électrique, de l'ordre de 4%, est encore réduite lorsque la structure de vanne de spin est traversée par un courant de mesure, en raison d'une autopolarisation de l'aimantation de la couche "libre" sous l'effet d'un champ magnétique créé par le courant de mesure ; ce courant de mesure atteint des valeurs de l'ordre de $10^7$ A/cm$^2$.

Ainsi, ce type de structure ne permet pas de réaliser une mesure avec une très bonne sensibilité.

On peut aussi noter (référence 5) que le champ magnétique à mesurer est appliqué parallèlement à l'axe facile d'aimantation de la couche magnétique "libre", cet axe étant lui-même parallèle à la direction de piégeage de la deuxième couche magnétique. Il en résulte une réponse quasiment en "marche d'escalier" de la résistance de la structure.

Le document (6) référencé à la fin de la présente description concerne un capteur magnétorésistif mettant également à profit l'effet de vanne de spin mais dans une structure à double vanne de spin. Cette structure comprend trois couches magnétiques séparées les unes des autres par un métal non magnétique. Les aimantations des deux couches ferromagnétiques extérieures sont maintenues fixes et parallèles entre elles par anisotropie d'échange avec des couches de matériau antiferromagnétique adjacentes qui leur sont respectivement associées. La couche magnétique centrale est formée d'un matériau magnétiquement doux et son aimantation est orientée sensiblement perpendiculairement à celle des deux couches externes, en l'absence de champ magnétique appliqué. Cette structure offre un effet de magnétorésistance avec une amplitude plus importante qu'une vanne de spin simple. Il n'est cependant pas facile de piéger par anisotropie d'échange, l'aimantation de la première couche magnétique.

Le matériau antiferromagnétique retenu dans le document (5) est un alliage FeMn, en raison de ses bonnes propriétés d'anisotropie d'échange. Ces propriétés ne se manifestent toutefois que si le FeMn est dans sa phase cristallographique cubique, à faces centrées (cfc). Ainsi, il est nécessaire de prévoir une sous-couche de NiFe pour conférer à la couche de FeMn ses propriétés, et obtenir un bon piégeage de la première couche ferromagnétique de la double vanne de spin. La nécessité d'obtenir une couche de FeMn dans sa phase cristallographique cfc complique donc la fabrication de telles structures. Par ailleurs, une partie du courant de mesure est dérivée dans la sous-couche de NiFe qui ne contribue pas à l'effet de magnétorésistance et l'amplitude de la variation de la résistance sous l'effet d'un champ magnétique est réduite.

Un but de la présente invention est de proposer une magnétorésistance qui ne présente pas les inconvénients mentionnés ci-dessus.

Un autre but de la présente invention est de proposer une magnétorésistance de bonne sensibilité présentant une forte variation de la résistance sous l'effet d'un champ magnétique extérieur appliqué.

Un autre but de la présente invention est de proposer une magnétorésistance dont le fonctionnement permet de s'affranchir de l'effet néfaste du phénomène d'autopolarisation créé par le courant de mesure dans les couches ferromagnétiques des structures à vanne de spin.

Un but de la présente invention est aussi de proposer une magnétorésistance de réalisation simple et un capteur magnétorésistif de bonne sensibilité.

Exposé de l'invention

Pour atteindre ces buts, l'invention propose un capteur de champ magnétique et son procédé de fabrication tels que définis dans les revendications.

On entend par aimantation piégée une aimantation qui reste sensiblement constante dans toute la gamme de champs magnétiques que l'on cherche à mesurer.

La structure proposée offre une amplitude de magnétorésistance significativement plus grande que les structures de vanne de spin ne comprenant que deux couches magnétiques. L'amplitude de la magnétorésistance est de 50 à 100% plus élevée qu'avec une structure vanne de spin simple, par suite de la présence de trois couches magnétiques au lieu de deux. De plus, la deuxième couche magnétique, libre, se trouve dans cette structure approximativement au centre de la nappe de courant qui circule à travers la magnétorésistance multicouche. De ce fait, le champ de polarisation créé par le courant de mesure est quasiment nul au niveau de cette couche, ce qui lui permet de conserver une susceptibilité élevée même en présence d'une densité de courant importante.

Par ailleurs, par rapport à la structure de double vanne de spin décrite dans le document (6), la présente structure évite le dépôt d'une sous-couche de NiFe et d'une première couche de FeMn nécessaire au piégeage d'une des couches externes de matériau magnétique. Il en résulte une simplification de la fabrication. La suppression des sous-couches de NiFe et de FeMn permet aussi une plus grande amplitude de l'effet de magnétorésistance par suite de la suppression de la dérivation du courant dans ces deux sous-couches qui ne participent pas à l'effet de magnétorésistance.

Selon un aspect de la présente invention, en l'absence de champ magnétique extérieur, la deuxième couche peut présenter une aimantation sensiblement perpendiculaire à la direction de mesure, ce qui permet d'obtenir une réponse plus linéaire de la magnétorésistance à un champ magnétique à mesurer.

L'aimantation piégée de l'une des première et troisième couches ferromagnétiques peut être obtenue en réalisant cette couche en un alliage à base de cobalt et de fer contenant des terres rares anisotropes qui lui confèrent une forte coercitivité et qui permettent ainsi de "bloquer" l'aimantation de cette couche dans une direction souhaitée.

Une autre possibilité est d'adjoindre à la couche ferromagnétique une couche de matériau antiferromagnétique, en contact avec cette dernière, pour en bloquer l'aimantation par anisotropie d'échange.

Selon un autre aspect de l'invention, l'empilement peut comporter des couches intercalaires en un matériau comprenant du cobalt entre respectivement chaque couche ferromagnétique et chaque couche non magnétique adjacente.

Ces couches de cobalt ou d'alliage comportant majoritairement du cobalt, permettent d'améliorer encore l'effet de magnétorésistance.

L'invention propose également un capteur équipé d'une magnétorésistance telle que décrite.

Cette magnétorésistance peut être réalisée selon un procédé de fabrication dans lequel on forme un empilement en déposant successivement sur un substrat une première couche de matériau ferromagnétique présentant une aimantation orientable sous l'effet d'un courant électrique, une couche de matériau conducteur non magnétique, une deuxième couche d'un matériau ferromagnétique doux, une deuxième couche de matériau conducteur non magnétique et une troisième couche de matériau ferromagnétique avec une aimantation piégée, un champ magnétique étant appliqué sensiblement perpendiculairement à la direction de mesure lors du dépôt de la deuxième couche de matériau ferromagnétique doux afin de conférer à cette dernière un axe de facile aimantation.

D'autres caractéristiques et avantages ressortiront mieux de la description qui va suivre, donnée à titre non limitatif et purement illustratif, en référence aux dessins annexés sur lesquels :

Brève description des figures

- la figure 1 est une vue éclatée des principales couches fonctionnelles d'une magnétorésistance conforme à l'invention,
- la figure 2 est une représentation schématique du champ magnétique créé par un courant de mesure dans la magnétorésistance,
- la figure 3 est une courbe représentant la variation de la tension aux bornes d'une magnétorésistance conforme à l'invention en fonction du champ à mesurer,
- la figure 4 est une coupe schématique d'une magnétorésistance conforme à l'invention,
- la figure 5 est une coupe schématique d'une magnétorésistance conforme à l'invention et constituant une variante par rapport à la figure 4.

Exposé détaillé de modes de réalisation

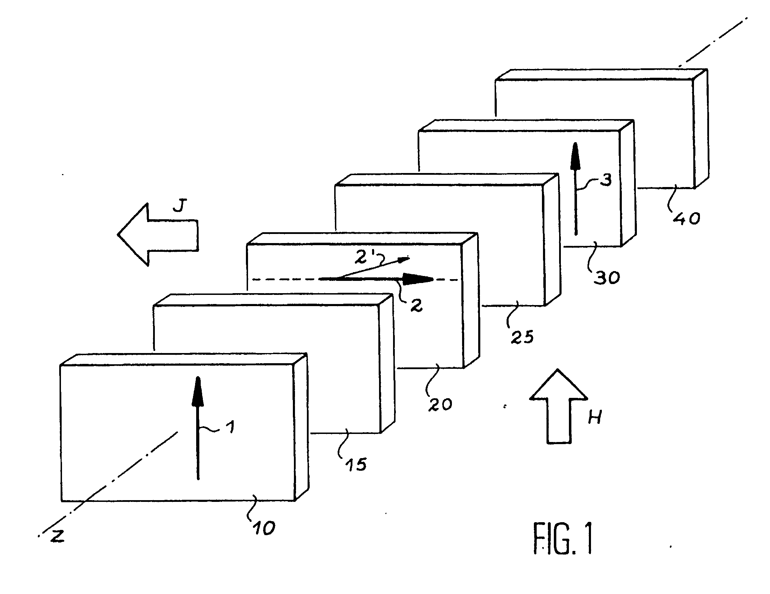

Comme le montre la figure 1, la structure en multicouches de la magnétorésistance comprend essentiellement trois couches 10, 20, 30 à base de métaux de transition ferromagnétiques (tel que le fer, le cobalt, le nickel ou leurs alliages) d'épaisseurs comprises entre quelques plans atomiques et environ une dizaine de nanomètres. Ces trois couches magnétiques sont séparées par deux couches 15, 25 de métal non magnétique, bon conducteur électrique, dont l'épaisseur doit être suffisante pour que les aimantations des couches magnétiques soient faiblement couplées à travers ces couches séparatrices, mais néanmoins bien inférieure au libre parcours moyen des électrons à travers le métal non magnétique. La gamme d'épaisseurs répondant à ces deux conditions s'étend d'environ 1,0 nm à 5 nm.

Les couches 15, 25 disposées respectivement entre les couches 10 et 20 d'une part et entre les couches 20 et 30 d'autre part sont de préférence en cuivre, en argent ou en or. Ce choix n'exclut toutefois pas d'autres métaux bons conducteurs tels que l'aluminium ou le platine, par exemple.

La structure de la magnétorésistance et les matériaux qui seront détaillés plus loin sont choisis de manière à présenter un effet de magnétorésistance géante. Cet effet se traduit, en l'occurrence, par un changement important de la résistivité lorsque l'orientation des couches change d'un état dit parallèle qui correspond à l'état où les couches 10, 20 et 30 présentent des aimantations parallèles entre elles, à un état dit antiparallèle où les aimantations des couches 10 et 30 sont parallèles, mais où l'aimantation de la couche 20 est sensiblement opposée à celle des couches 10 et 30.

L'aimantation de la couche 30 est piégée, c'est-à-dire bloquée dans la direction parallèle au champ à mesurer, ou direction de mesure. Le piégeage est assuré par un effet d'anisotropie d'échange avec une couche antiferromagnétique 40. La couche 40 est par exemple une couche de FeMn antiferromagnétique ou une couche de TbCo ferrimagnétique déposée sur la couche 30. Le piégeage magnétique de la couche 30 peut aussi être obtenu par d'autres moyens décrits plus loin.

La couche 20 est une couche de matériau magnétiquement doux dont la direction d'aimantation peut facilement être modifiée par le champ à mesurer appliqué à la magnétorésistance. Il s'agit par exemple d'une couche de Permalloy de composition $Ni_{80}Fe_{20}$.

Pour obtenir une réponse linéaire d'un capteur incluant une magnétorésistance conforme à l'invention, l'aimantation de la couche 20 est préférentiellement alignée sensiblement perpendiculairement à la direction de mesure lorsqu'un champ extérieur nul est appliqué à la magnétorésistance. Cette direction privilégiée d'orientation spontanée de l'aimantation de la couche 20 peut résulter d'effets d'anisotropie de forme de la magnétorésistance, où un axe de facile aimantation de la couche 20 est parallèle à la plus grande longueur de la magnétorésistance. On entend par axe de facile aimantation un axe correspondant à la direction spontanée d'orientation de l'aimantation du matériau en champ nul.

La direction privilégiée peut aussi, comme décrit plus loin, être imposée lors de la formation de la couche 20.

La couche 10, en un alliage à base de nickel, de fer et préférentiellement de cobalt, présente une aimantation qui n'est pas piégée en l'absence d'un courant circulant dans la magnétorésistance.

Par contre, lorsqu'un courant électrique, ici un courant de mesure, circule à travers la magnétorésistance, l'aimantation de la couche 10 s'oriente dans une direction sensiblement parallèle à l'aimantation de la couche 30, sous l'effet du champ magnétique créé par le courant électrique à l'intérieur de la magnétorésistance. Les flèches 1, 2 et 3 de la figure 1 montrent respectivement l'orientation des aimants des couches 10, 20 et 30 en l'absence de champ extérieur appliqué et en présence d'un courant de mesure J. La flèche 2' montre l'aimantation de la couche 20 modifiée en présence d'un champ H à mesurer.

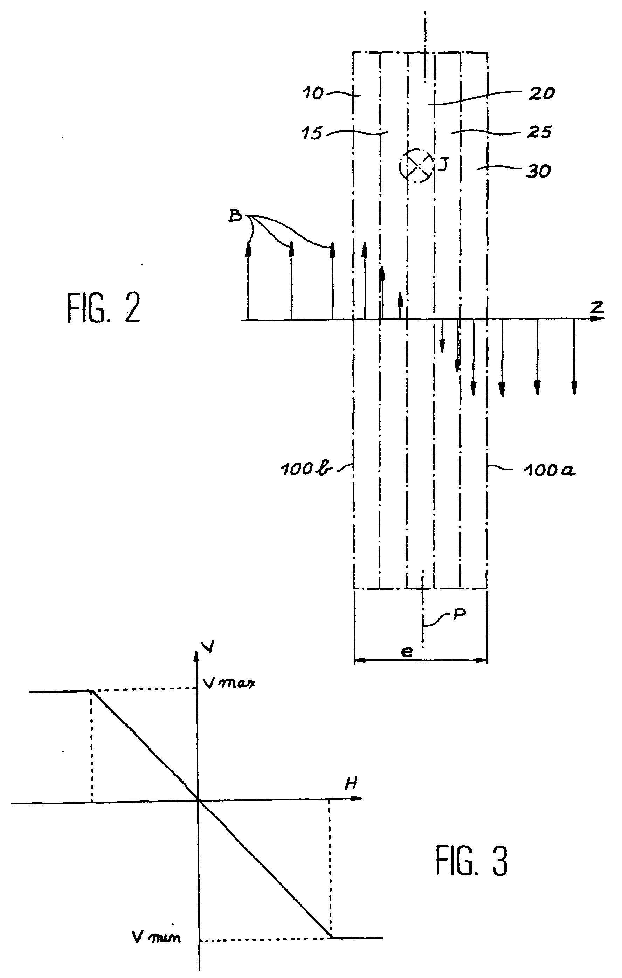

La flèche 1 indique la polarisation de la couche 10 sous l'effet du courant de mesure K. Cet effet peut être mieux compris avec la figure 2, sur laquelle le rectangle 100 figure une section transversale de la magnétorésistance multicouche perpendiculairement à sa plus grande longueur, et partant, perpendiculairement au courant de mesure J. Le rectangle 100 représente également une nappe uniforme du courant de mesure J traversant la magnétorésistance.

Lorsque le courant électrique de mesure J circule à travers la magnétorésistance avec une densité de courant j typiquement de l'ordre de 5./$10^6$) $5.10^7$ A/cm$^2$, ce courant électrique génère un champ magnétique B à l'intérieur du capteur qui peut être important en comparaison de l'ordre de grandeur du champ H que l'on cherche à mesurer. Supposons en effet que la densité de courant soit uniforme dans le matériau (égale à j) de sorte que le courant forme une nappe uniforme 100 sur toute l'épaisseur de la structure en multicouche. Le champ est alors nul dans le plan P médian, c'est-à-dire le plan parallèle aux surfaces extérieures et situé à la moitié de l'épaisseur de la structure multicouche, et augmente linéairement au fur et à mesure qu'on s'éloigne de ce plan P médian pour atteindre sa valeur maximale sur les surfaces latérales extérieures 100a et 100b de la magnétorésistance. En utilisant le théorème d'Ampère :

$$\oint_C \vec{H}\,\vec{dl} = I = \iint_S j\,dS \, ,$$

on montre que le champ magnétique créé par la nappe de courant à la cote z (la cote z=0 correspondant au plan médian) varie comme H(z)=jz. A titre d'exemple pour j=$2.10^7$ A/cm$^2$, H(z)=0,2z, où z est exprimé en nanomètre de H(z) en kA/m. Ainsi, pour un système en multicouche d'épaisseur totale e=20nm, le champ à la surface 100a ou 100b est de

$$H\left(\pm\frac{e}{2}\right) = \pm 2kA/m \, ,$$

comparable à un champ à mesurer de 1 à 2kA/m.

Comme la couche 20, dont l'emplacement est suggéré sur la figure 2, se trouve au voisinage du centre de la nappe de courant J s'écoulant à travers la magnétorésistance, le champ magnétique créé par le courant de mesure sur cette couche magnétique centrale est nul ou très faible par rapport au champ que l'on cherche à mesurer. De ce fait, l'aimantation de la couche centrale 20 peut facilement suivre les variations du champ extérieur appliqué à mesurer.

La couche 10 voisine de la surface 100b voit par contre un champ magnétique plus important créé par le courant de mesure. Ce champ agit sur l'aimantation de cette couche et l'oriente dans une direction sensiblement parallèle à la direction de mesure.

Pour les valeurs usuelles du courant de mesure, le champ magnétique d'autopolarisation (H) est, par contre, trop faible pour affecter la direction de l'aimantation de la couche piégée 30.

De toute façon, il est possible de choisir le sens de circulation du courant électrique ou la direction initiale de piégeage de l'aimantation de la couche 30 de sorte que les aimantations des couches 10 et 30 soient sensiblement parallèles en présence d'un courant de mesure, par exemple, de l'ordre de $2.10^7$ A/m$^2$, et en l'absence de champ extérieur.

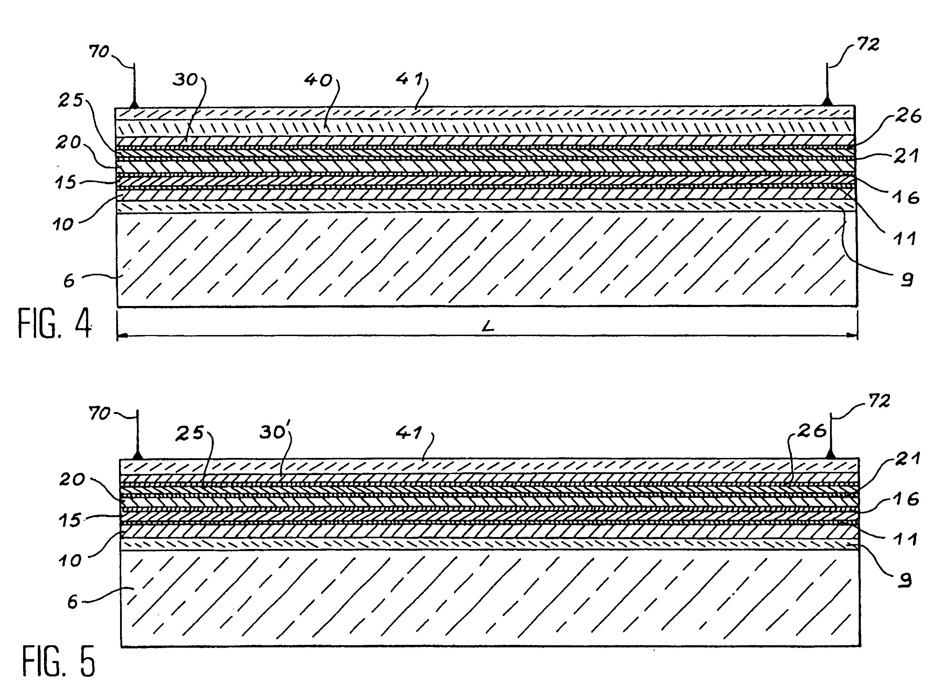

La figure 3 illustre la variation de la tension aux bornes de la magnétorésistance en fonction du champ à mesurer. Les bornes 70, 72 sont visibles par exemple sur les figures 4 ou 5. Pour un champ H de l'ordre de 1 kA/m, les aimantations des trois couches magnétiques 10, 20, 30 sont parallèles. La résistivité de la magnétorésistance est alors minimale et il en résulte une tension $V_{min}$ minimale aux bornes. Pour un champ H de l'ordre de -1 kA/m, l'aimantation de la couche 20 devient opposée aux aimantations des couches 10 et 30 demeurent sensiblement parallèles entre elles. Lorsque la valeur du champ H augmente, la résistivité diminue de quelques pour-cents, ce qui conduit également à une diminution de la tension de l'ordre de 1 mV. Entre les deux limites $V_{max}$ et $V_{min}$, la variation de la tension est sensiblement linéaire. Une légère asymétrie par rapport au champ nul peut exister si un couplage magnétique entre la couche 20 et les couches 10 et 30 à travers les métaux non magnétiques des couches 15 et 25 subsiste. Il est connu qu'un tel couplage magnétique existe pour de faibles épaisseurs de matériaux magnétiques. Mais, avec les matériaux des couches 15 et 25, en particulier le cuivre et l'argent déposés à basse température, ainsi que l'or, ce couplage diminue rapidement avec des épaisseurs de ces couches supérieures à 2 nm.

Les figures 4 et 5 illustrent de façon plus détaillée la structure de magnétorésistances conforme à l'invention selon deux variantes de mise en oeuvre. Ces figures donnent aussi un exemple de l'ordre de la formation des couches dans un procédé de fabrication de la magnétorésistance conforme à l'invention.

Des éléments identiques ou similaires des figures portent des références en correspondance.

Dans l'exemple de la figure 4, la magnétorésistance est formée sur un substrat 6 de silicium. Elle comporte, dans l'ordre à partir du substrat, successivement des couches dont la référence, la nature et l'épaisseur sont données à titre d'exemple dans le tableau I.

## TABLEAU I

| REFERENCE DE LA COUCHE | MATERIAU | EPAISSEUR EN nm |
|---|---|---|
| 9 | Ta | 5 |
| 10 | $Ni_{80}Fe_{20}$ | 6 |
| 11 | $Co_{70}Fe_{30}$ | 0,6 |
| 15 | Ag | 2,5 |
| 16 | $Co_{70}Fe_{30}$ | 0,6 |
| 20 | $Ni_{80}Fe_{20}$ | 5 |
| 21 | $Co_{70}Fe_{30}$ | 0,6 |
| 25 | Ag | 2,5 |
| 26 | $Co_{70}Fe_{30}$ | 0,6 |
| 30 | $Ni_{80}Fe_{20}$ | 4 |
| 40 | $Fe_{50}Mn_{50}$ | 8 |
| 41 | Ta | 5 |

Les couches de la magnétorésistance peuvent être formées par pulvérisation cathodique par exemple.

Lorsque l'argent est utilisé pour la formation des couches 15 et 25, il est avantageux de refroidir le substrat à l'azote liquide, afin d'obtenir une bonne structure de ces couches. On peut se reporter à ce sujet, par exemple, au document (7) référencé à la fin de la présente description. Comme déjà évoqué, les couches 15 et 25 peuvent aussi être réalisées en cuivre ou en or, ce qui dispense du refroidissement du substrat. Ces matériaux n'offrent cependant pas une aussi bonne stabilité thermique que l'argent au cours de recuits subséquents.

Conformément à l'invention, on applique un champ magnétique sensiblement perpendiculaire à la direction de mesure lors du dépôt de la couche 20. Ce champ magnétique d'une valeur de l'ordre de 800 à 8000 A/m (10 à 100 Oe), permet d'induire un axe de facile aimantation dans la couche "centrale" 20.

Comme le montre la figure 4, la magnétorésistance a aussi une forme allongée, en forme de barreau par exemple, dont la longueur L est de préférence parallèle à cet axe de facile aimantation. Ainsi, un effet d'anisotropie de forme contribue également à l'orientation de l'aimantation de la couche magnétique 20 suivant son axe de facile aimantation. Dans les exemples des figures 4 ou 5, le courant de mesure circule suivant la grande longueur du barreau.

L'aimantation de la couche 30 peut être orientée et piégée perpendiculairement à l'axe de facile aimantation de la couche 20 en chauffant la structure jusqu'à une température juste au-dessus de la température de Néel de la couche 41 en $Fe_{50}Mn_{50}$, c'est-à-dire à une température voisine de 200°C, puis en refroidissant la structure en appliquant un champ magnétique dans la direction de piégeage désirée, en l'occurrence sensiblement parallèlement à la direction de mesure. On rappelle que la température de Néel est la température en-dessous de laquelle les spins d'un matériau antiferromagnétique sont ordonnés en un arrangement antiparallèle.

A titre d'illustration, on peut se reporter au document (8) référencé à la fin de la présente description.

Selon une variante de mise en oeuvre de l'invention correspondant à la figure 5, la magnétorésistance ne comporte pas de couche antiferromagnétique 40. A l'exception de la couche 40, la structure de la magnétorésistance est donc similaire à celle de la figure 4. Toutefois, la couche 30' correspondant à la couche 30 de la figure 4, est une couche en un matériau fortement coercitif pour laquelle l'aimantation est insensible à tout champ extérieur inférieur à une dizaine de kA/m. La couche 30' est par exemple un alliage de fer et de cobalt avec une adjonction de terres rares anisotropes choisies parmi le samarium, le néodyme, le terbium et le dysprosium.

Les couches 11, 16, 21 et 26 dont la présence est certes facultative, constituent néanmoins un perfectionnement intéressant de l'invention. Ces couches de cobalt ou d'alliage $Co_{1-x}Fe_x$ avec $0 \leq x \leq 0,3$, d'une épaisseur de 0,2 à 1 nm permettent en effet d'augmenter notablement l'amplitude de l'effet de magnétorésistance géante sans pour autant trop augmenter le champ de saturation ou l'hystérésis de la couche 20.

Un autre perfectionnement de l'invention consiste à remplacer le matériau des couches 10 et 30 par du cobalt ou par des alliages riches en cobalt tels que $Co_{70}Fe_{30}$. La couche 20 reste toutefois en un matériau magnétiquement doux.

Une magnétorésistance telle que décrite ci-dessus peut être utilisée dans la fabrication d'un capteur magnétorésistif. Dans ce cas des connexions 70, 72, schématiquement représentées à la figure 4 peuvent être disposées aux extrémités de la magnétorésistance, prise dans le sens de sa longueur. Les connexions permettent de la relier à un circuit de mesure non représenté.

Un courant de mesure de l'ordre de $2.0^7 A/cm^2$ permet de créer au niveau de la couche 10 un champ de l'ordre de 1600 A/m (20 Oe) suffisant pour orienter l'aimantation de la couche 10 sensiblement perpendiculairement à celle de la couche 20. Le sens du courant de mesure dans le capteur est alors choisi pour que les aimantations des couches 10 et 30 soient parallèles et non pas antiparallèles.

## DOCUMENTS CITES DANS LA PRESENTE DEMANDE

*(1)*
D.A. Thompson et al., IEEE Trans. Mag. Mag-11, p. 1039 (1975).

*(2)*
IEEE Translation Journal on magnetics in Japan, vol. 7, N°9, September 1992, "Magnetoresistance of multilayers" de H. Yamamoto and T. Shinjo, pp. 674-684.

*(3)*
B. DIENY, Journal of Magnetism and magnetic Materials 136 (1994), pp. 335-359.

*(4)*
US-A-4 949 039

*(5)*
Physical review B, vol. 43, n°1, 1 January 1991, "Giant magnetoresistance in soft ferromagnetic multilayers" de B. Dieny et al., pp. 1297-1300.

(6)
US-A-5 287 238

(7)
FR-A-2 698 965

(8)
US-A-625 343

**Revendications**

1. Capteur de champ magnétique comperant :

   - une magnétorésistance comportant un empilement d'une première (10), d'une deuxième (20) et d'une troisième (30) couches de matériau ferromagnétique, la deuxième couche (20) étant séparée de la première (10) et de la troisième (30) couches respectivement par une première (15) et une seconde (25) couches de matériau conducteur électrique et non magnétique, ladite deuxième couche étant réalisée en un matériau doux présentant une aimantation pouvant être modifiée par un champ magnétique (H) extérieur, et
   - des moyens d'application d'un courant de mesure à travers la magnétorésistance,

   **caractérisé en ce que** l'une des première (10) et troisième (30) couches présente une aimantation piégée dans une direction de piégeage tandis que l'autre couche présente une aimantation orientable sous l'effet du courant électrique de mesure (J) traversant la magnétorésistance, le sens de circulation du courant électrique ou la direction de piégeage étant choisis de sorte que les première et troisième couches présentent une aimantation parallèle et non pas antiparallèle lorsque le courant de mesure est appliqué.

2. Capteur selon la revendication 1, **caractérisé en ce qu'**en l'absence de champ magnétique extérieur, la deuxième couche (20) présente une aimantation sensiblement perpendiculaire à la direction de mesure.

3. Capteur selon la revendication 1, **caractérisé en ce que** le matériau non magnétique est choisi parmi le cuivre, l'argent et l'or.

4. Capteur selon la revendication 1, **caractérisé en ce que** les couches (15, 25) de matériau non magnétique présentent une épaisseur comprise entre 1,0 nm et 5 nm.

5. Capteur selon la revendication 1, **caractérisé en ce que** la couche présentant une aimantation piégée (30) est réalisée en un alliage à forte coercitivité à base de cobalt et de fer contenant des terres rares anisotropes.

6. Capteur selon la revendication 1, **caractérisé en ce que** l'empilement comporte en outre une couche de matériau antiferromagnétique (40) en contact avec la couche présentant une aimantation piégée (30) pour en bloquer l'aimantation..

7. Capteur selon la revendication 1, **caractérisé en ce que** l'empilement comporte des couches intercalaires (11, 16, 21, 26) en un matériau comprenant du cobalt respectivement entre chaque couche ferromagnétique (10, 20, 30) et entre chaque couche non magnétique (15, 25) adjacente.

8. Capteur selon la revendication 7, **caractérisé en ce que** les couches intercalaires (11, 16, 21, 26) sont en un alliage $Co_{(1-x)}Fe_x$ où $0 \leq x \leq 0,3$.

9. Procédé de fabrication d'un capteur selon la revendication 1, **caractérisé en ce qu'**on forme un empilement en déposant successivement sur un substrat une première couche (10) de matériau ferromagnétique présentant une aimantation orientable sous l'effet d'un courant électrique, une couche de matériau conducteur non magnétique (15), une deuxième couche d'un matériau ferromagnétique doux (20), une deuxième couche de matériau conducteur non magnétique (25) et une troisième couche de matériau ferromagnétique (30) avec une aimantation piégée, un champ magnétique étant appliqué sensiblement perpendiculairement à la direction de mesure lors du dépôt de la deuxième couche (20) de matériau ferromagnétique doux afin de conférer à cette dernière un axe de facile aimantation.

10. Procédé selon la revendication 9, **caractérisé en ce qu'**on dépose les couches par pulvérisation cathodique.

11. Procédé selon la revendication 9, **caractérisé en ce qu'**on dépose une couche (40) d'alliage antiferromagnétique $Fe_{50}Mn_{50}$ sur la troisième couche (30) ferromagnétique, on chauffe l'empilement à une température supérieure à la température de Néel de la couche antiferromagnétique et on refroidit l'empilement en appliquant un champ magnétique parallèlement à la direction de mesure.

12. Procédé selon la revendication 9, **caractérisé en ce qu'**avant le dépôt de la première couche de matériau ferromagnétique (10) sur le substrat, on forme sur le substrat une couche de tantale (9).

**Patentansprüche**

1. Magnetfeldsensor, umfassend:

   - einen Magnetowiderstand, gebildet durch einen Stapel aus einer ersten (10), zweiten (20) und dritten (30) Schicht aus ferromagnetischem Material, wobei die zweite Schicht (20) von der ersten (10) und der dritten (30) Schicht jeweils durch eine erste (15) und eine zweite (25) Schicht aus elektrisch leitfähigem und unmagnetischem Material getrennt wird, und die genannte zweite Schicht durch ein weiches bzw. weichmagnetisches Material gebildet wird, das eine Magnetisierung aufweist, die durch ein äußeres Magnetfeld (H) modifiziert werden kann, und
   - Einrichtungen zur Anwendung eines Messstroms durch den Magnetowiderstand hindurch,

   **dadurch gekennzeichnet,**
   **dass** eine der Schichten, die erste (10) oder die dritte (30), eine in einer Fixierungsrichtung festgelegte Magnetisierung aufweist, und die jeweils andere Schicht eine durch die Wirkung des den Magnetowiderstand durchquerenden elektrischen Messstroms (J) ausnchtbare Magnetisierung aufweist, wobei die Fließrichtung des elektrischen Stroms und die Fixierungsrichtung so gewählt werden, dass die erste und die dritte Schicht eine parallele und nicht antiparallele Magnetisierung aufweisen, wenn der Messstrom angewendet wird.

2. Sensor nach Anspruch 1, **dadurch gekennzeichnet, dass** bei Fehlen des äußeren Magnetfeldes die zweite Schicht (20) eine im Wesentlichen zu der Messrichtung senkrechte Magnetisierung aufweist.

3. Sensor nach Anspruch 1, **dadurch gekennzeichnet, dass** das unmagnetische Material ausgewählt wird unter Kupfer, Silber und Gold.

4. Sensor nach Anspruch 1, **dadurch gekennzeichnet, dass** die Schichten (15, 25) aus unmagnetischem Material eine zwischen 1,0 nm und 5 nm enthaltene Dicke aufweisen.

5. Sensor nach Anspruch 1, **dadurch gekennzeichnet, dass** die eine fixierte Magnetisierung aufweisende Schicht (30) durch eine auf Kobalt und Eisen mit anisotropen Seltenen Erden basierende Legierung mit starker Koerzitivkraft gebildet wird.

6. Sensor nach Anspruch 1, **dadurch gekennzeichnet, dass** der Stapel außerdem eine Schicht (40) aus antiferromagnetischem Material umfasst, die Kontakt hat mit der eine fixierte Magnetisierung aufweisenden Schicht (30), um deren Magnetisierung zu blockieren.

7. Sensor nach Anspruch 1, **dadurch gekennzeichnet, dass** der Stapel jeweils zwischen jeder ferromagnetischen Schicht (10, 20, 30) und zwischen jeder angrenzenden unmagnetischen Schicht (15, 25) Zwischenschichten (11, 16, 21, 26) aus einem Kobalt enthaltenden Material umfasst.

8. Sensor nach Anspruch 7, **dadurch gekennzeichnet, dass** die Zwischenschichten (11, 16, 21, 26) durch eine $Co_{(1-x)}Fe_x$-Legierung gebildet wird, mit $0 \leq x \leq 0,3$.

9. Verfahren zur Herstellung eines Sensors nach Anspruch 1, **dadurch gekennzeichnet, dass** man durch sukzessives Abscheiden auf einem Substrat einen Stapel mit einer ersten Schicht (10) aus ferromagnetischem Material mit einer unter der Wirkung eines elektrischen Stroms ausrichtbaren Magnetisierung, einer Schicht (15) aus unmagnetischem leitfähigem Material, einer zweiten Schicht (20) aus einem weichferromagnetischen Material, einer zweiten Schicht (25) aus unmagnetischem leitfähigem Material und einer dritten Schicht (30) aus ferromagnetischem Material mit einer fixierten Magnetisierung bildet, wobei während der Abscheidung der zweiten Schicht (20) aus weichferromagnetischem Material ein Magnetfeld im Wesentlichen senkrecht zu der Messrichtung angewendet wird, um dieser Schicht eine Achse leichter Magnetisierbarkeit zu verleihen.

10. Verfahren nach Anspruch 9, **dadurch gekennzeichnet, dass** man die Schichten durch Kathodenzerstäubung herstellt.

11. Verfahren nach Anspruch 9, **dadurch gekennzeichnet, dass** man auf der dritten ferromagnetischen Schicht (30) eine Schicht (40) aus antiferromagnetischer $Fe_{50}Mn_{50}$-Legierung abscheidet, man den Stapel auf eine Temperatur erwärmt, die höher ist als die Néel-Temperatur der antiferromagnetischen Schicht, und man beim Abkühlen des Stapels parallel zu der Messrichtung ein Magnetfeld anwendet.

**12.** Verfahren nach Anspruch 9, **dadurch gekennzeichnet, dass** man vor dem Abscheiden der ersten antiferromagnetischen Schicht (10) auf dem Substrat auf diesem Substrat eine Tantalschicht (9) ausbildet.

## Claims

**1.** Magnetic field sensor comprising a magnetoresistance having a stack of a first (10), a second (20) and a third (30) ferromagnetic material layers, the second layer (20) being separated from the first (10) and third (30) layers respectively by a first (15) and a second (25) non-magnetic, electrically conductive material layers, and made from a soft material having a magnetization which can be modified by an external magnetic field (H), means for applying a measuring current across the magnetoresistance, **characterized in that** one of the first and third layers has a trapped magnetization in a so-called measuring direction, whilst the other layer has a magnetization orientable in said measuring direction under the effect of a measuring current (J) traversing the magnetoresistance, the electric current flow direction or the trapping direction being chosen in such a way that the first and third layers have a parallel magnetization and not an antiparallel magnetization when the measuring current is applied.

**2.** Sensor according to claim 1, **characterized in that** in the absence of an external magnetic field, the second layer (20) has a magnetization substantially perpendicular to the measuring direction.

**3.** Sensor according to claim 1, **characterized in that** the non-magnetic material is chosen from among copper, silver and gold.

**4.** Sensor according to claim 1, **characterized in that** the non-magnetic material layers have a thickness between 1 and 5 nm.

**5.** Sensor according to claim 1, **characterized in that** the layer having a trapped magnetization (30) is made from a high coercivity alloy based on cobalt and iron containing anisotropic rare earths.

**6.** Sensor according to claim 1, **characterized in that** the stack also has an antiferromagnetic material layer (40) in contact with the layer (30) having a trapped magnetization in order to block the magnetization thereof.

**7.** Sensor according to claim 1, **characterized in that** the stack has separating layers (11, 16, 21, 26) made from a material incorporating cobalt respectively between each ferromagnetic layer (10, 20, 30) and between each adjacent non-magnetic layer (15, 25).

**8.** Sensor according to claim 7, **characterized in that** the separating layers (11, 16, 21, 26) are of an alloy $Co_{(1-x)}OFe_x$ in which $0 \leq x \leq 0.3$.

**9.** Process for the production of a sensor according to claim 1, **characterized in that** formation takes place of a stack by successively depositing on a substrate a first ferromagnetic material layer (10) having a magnetization orientable under the effect of an electric current, a conductive, non-magnetic material layer (15), a second soft ferromagnetic material layer (20), a second conductive, non-magnetic material layer (25) and a third ferromagnetic material layer (30) with a trapped magnetization, a magnetic field being applied substantially perpendicular to the measuring direction during the deposition of the second, soft ferromagnetic material layer (20) in order to give the latter an axis of easy magnetization.

**10.** Process according to claim 9, **characterized in that** the layers are deposited by cathodic sputtering.

**11.** Process according to claim 9, **characterized in that** deposition takes place of a $Fe_{50}Mn_{50}$ antiferromagnetic alloy layer (40) on the third ferromagnetic layer (30), the stack is heated to a temperature exceeding the Néel temperature of the antiferromagnetic layer and the stack is cooled by applying a magnetic field parallel to the measuring direction.

**12.** Process according to claim 9, **characterized in that**, prior to the deposition of the first ferromagnetic material layer (10) to the substrate, a tantalum layer (9) is formed on the substrate.

FIG. 1

FIG. 2

FIG. 3

FIG. 4

FIG. 5

EP 0 724 302 B1